# FASCICULE DE BREVET EUROPEEN

(11) **EP 1 523 757 B1**
(45) Date de publication et mention de la délivrance du brevet: **04.10.2006**
(21) Numéro de dépôt: 03763935.8
(22) Date de dépôt: 08.07.2003
(51) Int. Cl.: H01J 37/34

(54) **CATHODE POUR MACHINE DE TRAITEMENT PAR PULVERISATION SOUS VIDE**
KATHODE FÜR VAKUUMZERSTÄUBUNGSBEHANDLUNGSVORRICHTUNG
CATHODE FOR VACUUM SPUTTERING TREATMENT MACHINE

(30) Priorité: 10.07.2002 FR 0208868
(43) Date de publication de la demande: 20.04.2005
(73) Titulaire: Tecmachine, 42160 Andrézieux-Bouthéon (FR)
(72) Inventeur: AULAGNER, Michel, F-43330 ST Ferreol D'auroure (FR); LABALME, Lionel, F-42170 St Just St Rambert (FR)
(74) Mandataire: Thivillier, Patrick
(86) Numéro de dépôt international: PCT/FR2003/002110
(87) Numéro de publication internationale: WO 2004/008478

(56) Documents cités:
- DE-U- 29 512 094
- US-A- 5 147 521
- US-A- 5 269 894
- US-A- 5 863 397

## Description

L'invention se rattache au secteur technique de la pulvérisation cathodique d'un matériau notamment dans une installation de traitement sous vide.

Il est notoirement connu, pour un homme du métier, d'utiliser des cathodes pour pulvériser un matériau à partir d'une cible, en combinaison avec une anode. Dans une installation de pulvérisation cathodique classique, la tension négative est appliquée à la cible faisant office de cathode lors de la pulvérisation, tandis que la source de tension positive est reliée à une anode distincte, par exemple dans une chambre de traitement sous vide.

L'état antérieur de la technique peut être illustré, à titre indicatif et non limitatif, par l'enseignement du brevet FR 2492163 qui concerne un agencement de cathode pour pulvériser un matériau d'une cible dans une installation de pulvérisation cathodique. Dans ce brevet, la cible comporte une plaque support présentant des agencements pour la circulation d'un fluide de refroidissement. La cible est maintenue en position au moyen d'un bridge périphérique vissé dans l'épaisseur de la plaque de refroidissement et, dans l'épaisseur d'une embase ou culasse portant plaque de refroidissement. Généralement, entre la cible et la plaque de refroidissement est montée une membrane.

Dans ce type d'installation, il est nécessaire de changer très souvent la cible, en fonction des applications.

Concernant les solutions de l'état de la technique, quelles que soient les formes de réalisations, les moyens de fixation de la cible ne permettent pas sa manipulation et son interchangeabilité aisée.

Souvent la cible est fixée au moyen d'une pluralité de vis disposées périphériquement. Si l'on considère le nombre de vis très important nécessaires pour assurer la fixation de la cible, il est évident que le temps du montage et du démontage est particulièrement long. Par ailleurs, des risques de grippage peuvent apparaître.

Il est également proposé d'assurer la fixation de la cible au moyen d'un bridage facial, en combinaison avec des vis. Cette solution n'est toujours pas satisfaisante, étant donné que là encore se sont les vis qui participent directement au serrage ensemble de la cible. Une telle solution ressort par exemple de l'enseignement du brevet FR 2492163 précité.

On peut citer également l'enseignement du brevet US-A-5269894 qui divulgue une cathode pour machine de traitement par pulvérisation sous vide comprenant une plaque cible montée sur un support agencé pour faire office de refroidisseur. Le support est rendu solidaire d'un cadre délimitant un espace fermé pour le positionnement et le centrage de la cible.

L'invention s'est fixée pour but de remédier à ces inconvénients de manière simple, sure, efficace et rationnelle.

Le problème que se propose de résoudre l'invention est d'assurer la fixation de la cible de manière rapide et efficace, en permettant par conséquent son démontage et remontage rapide, en vue de son remplacement.

Pour résoudre un tel problème, il a été mis au point une cathode pour machine de traitement par pulvérisation sous vide selon la revendication 1. La cathode comprend une plaque cible montée sur un support agencé pour faire office de refroidisseur, le support étant rendu solidaire d'un cadre délimitant un espace fermé pour le positionnement et le centrage de la cible ; ledit cadre présente périphériquement un rebord d'accrochage et d'emboîtement profilé apte à coopérer avec un ensemble d'éléments de pincement indépendants présentant des formes d'accrochage complémentaires aptes à autoriser un effet de basculement desdits éléments résultant d'une action de serrage exercée sur des organes engagés dans l'épaisseur des éléments en appui sur une partie du rebord d'accrochage du cadre, de sorte que sous ledit effet de basculement une partie des formes d'accrochage de l'ensemble d'éléments de pincement prend appui facialement sur le bord périphérique de la cible en vue de sa fixation.

Pour résoudre le problème posé d'assurer une fixation sure et efficace de la cible, l'ensemble des éléments de pincement sont convenablement découpés pour constituer, après assemblage en juxtaposition, un cadre périphérique fermé entourant et enfermant totalement les quatre côtés de la cible en délimitant une zone de centrage libre pour la pulvérisation.

Compte tenu du profil spécifique des formes d'accrochage, et de la nécessité de pouvoir remplacer rapidement la cible, les éléments de pincement, ou certains d'entre eux, présentent au moins un bord biseauté pour former les angles tandis que d'autres sont droits pour être insérés par glissement, entre deux éléments d'angle notamment, préalablement positionnés par rapport au cadre.

Pour résoudre le problème posé de permettre le basculement des éléments de pincement, sous l'effet de serrage, les organes sont des vis de pression.

Pour résoudre le problème posé d'assurer la fixation de la cible, sous l'effet de basculement des éléments de pincement, les rebords d'accrochage et d'emboîtement du cadre sont constitués par un profil rectiligne déporté délimitant une rainure rectiligne. Les formes complémentaires d'accrochage des éléments de pincement, sont constituées par une gorge rectiligne coopérant avec le profil rectiligne déporté et délimitant un bec coopérant avec la rainure pour provoquer l'effet de basculement sous l'action de serrage.

Un autre problème que se propose de résoudre l'invention, est de pouvoir intervenir facilement sur l'ensemble de la cathode notamment pour le changement de la cible de pulvérisation.

Pour résoudre un tel problème, le support est monté sur une partie de la machine agencée pour être facilement extractable.

Avantageusement, la partie considérée de machine constitue une porte.

L'invention est exposée ci-après plus en détail à l'aide des figures des dessins annexés dans lesquels :
- La figure 1 est une vue en plan d'une partie de cathode de pulvérisation , avant mise en place des éléments de pincement pour la fixation de la cible.
- La figure 2 est une vue correspondant à la figure 1 après mise en place des éléments de pincement.
- La figure 3 est une vue en coupe illustrant la réalisation et l'application de la cathode au niveau du serrage de la cible.
- La figure 4 est une vue correspondant à la figure 3 pour le serrage de la cible.
- La figure 5 est une vue partielle en perspective montrant les profils en section du support à membrane et des éléments de pincement.

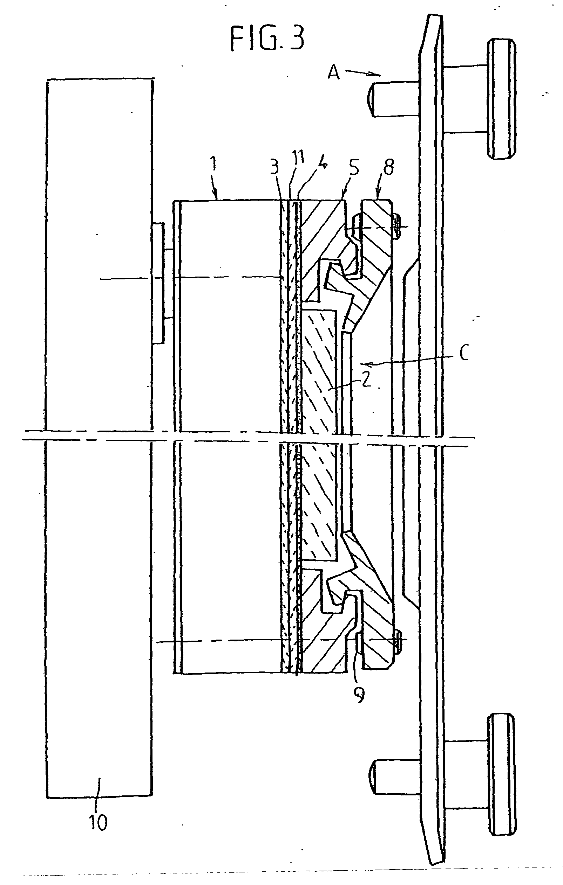

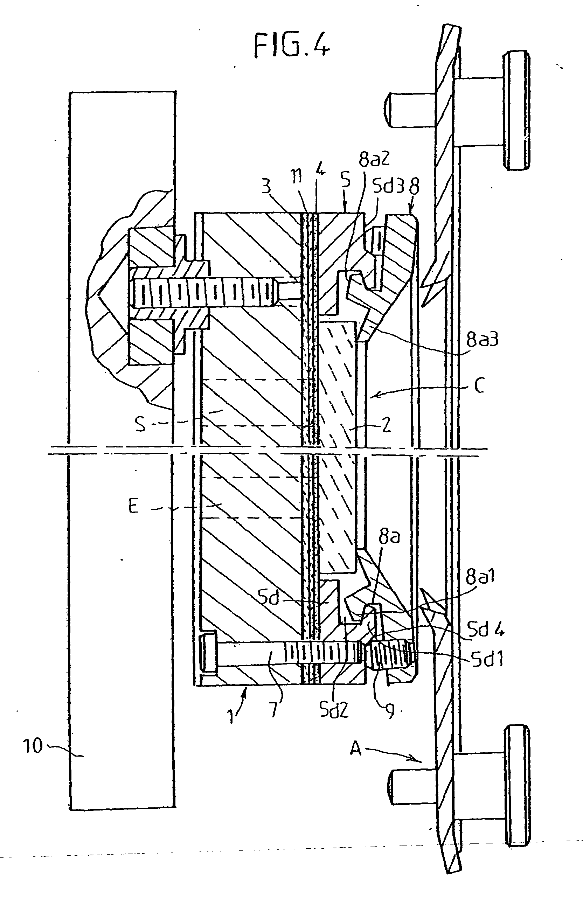

Comme le montrent les figures 3 et 4 la cathode trouve une application particulièrement avantageuse, qui ne saurait cependant être considérée comme limitative, pour le traitement par pulvérisation sous vide. Ces figures montrent de manière très schématique la cathode désigné dans son ensemble par (C) solidaire d'une culasse (1) par exemple. La partie de la machine sous vide qui fait office d'anode est désignée par (A).

La cathode (C) présente une cible de pulvérisation (2) de tout type connu et approprié et adaptée au traitement à effectuer. Cette cible (2) est montée sur un support (3) agencé pour faire office de refroidisseur. Dans l'exemple illustré, qui ne doit pas être considéré comme limitatif, le support (3) est à membrane et présente une entrée (E) et une sortie (S) d'un fluide de refroidissement. La membrane du support est désignée par (4).

Selon l'invention, le support à membrane (3) - (4) est rendu solidaire d'un cadre (5) délimitant un espace fermé (6) pour le positionnement et le centrage de la cible (2). Par exemple, lorsque la cible (2) a une forme générale rectangulaire, le cadre (5) peut être réalisé à partir de 4 profils rectilignes (5A) (5B) (5C) (5D) découpés et assemblés pour constituer un cadre fermé. Le cadre (5), ainsi réalisé, est fixé par exemple au moyen de vis (7) dans l'épaisseur du support à membrane (3)-(4) et la culasse (1).

Le cadre (5) présente périphériquement un rebord d'accrochage et d'emboîtement profilé (5d) apte à coopérer avec un ensemble d'éléments de pincement (8) présentant des formes d'accrochage complémentaires (8a).

Les profils d'accrochage (5d) et les formes complémentaires (8a) sont conformées en section pour autoriser un effet de basculement des éléments de pincement (8) résultant d'une action de serrage exercée sur des organes (9) engagés dans l'épaisseur desdits éléments (8) et en appui sur une partie du rebord d'accrochage du cadre (7). Sous l'effet de basculement, une partie des formes d'accrochage (8a) de l'ensemble des éléments de pincement (8) prend appui facialement sur le bord périphérique de la cible (2) en vue de sa fixation comme indiqué ci-après.

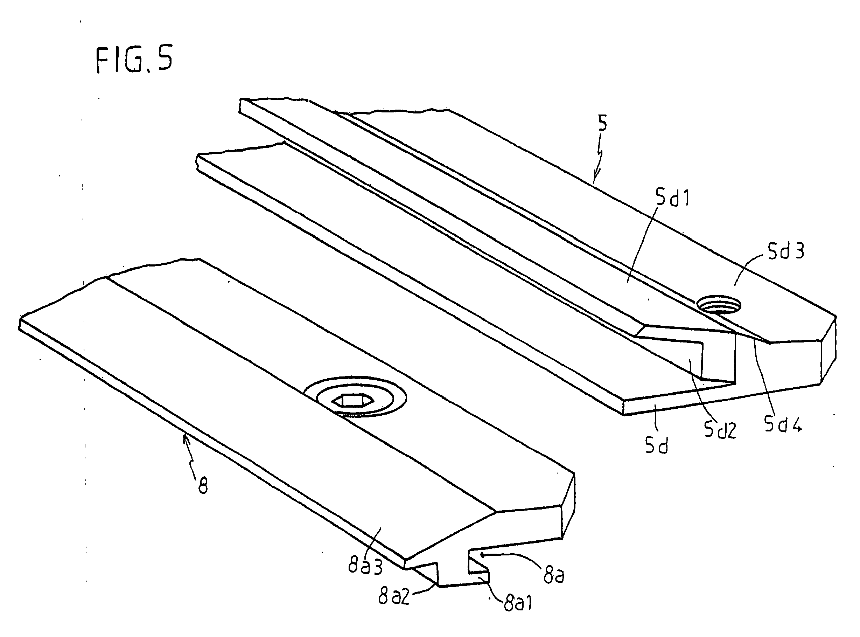

La figure 5 montre une réalisation avantageuse du profil en section du rebord d'accrochage (5d) du cadre (5), et les formes d'accrochage complémentaires (8a) des éléments de pincement (8).

Le rebord d'accrochage et d'emboîtement (5d) est constitué par un profil rectiligne déporté (5d1) délimitant une rainure rectiligne (5d2). Le profil rectiligne (5d1) est raccordé à une face d'appui (5d3) par une face inclinée (5d4).

Les formes complémentaires des éléments de pincement (8) sont constituées par une gorge rectiligne (8a1) qui est apte à être engagée sur le profil rectiligne déporté (5d1) du cadre (5). La gorge rectiligne (8a1) délimite un bec (8a2) coopérant avec une rainure (5d2). Le bec (A2) est établi en débordement d'une face d'appui inclinée (8a3) destinée à coopérer avec le rebord périphérique de la cible (2).

Après imbrication de la section transversale des éléments de pincement (8) dans les profils d'accrochage et d'emboîtement du cadre (5), (engagement du bec (8a2) dans la rainure (5d2) du profil (5d) dans la gorge (8a1)), il suffit d'agir sur les organes (9) pour créer l'effet de basculement des éléments de pincement (8). Dans ce but, les organes (9) sont constitués par des vis de pression intégrées dans l'épaisseur des éléments (8), sous les formes d'accrochage (8a), et en appui au niveau de la face inclinée de raccordement (5d4) du cadre (5).

La figure 3 montre les éléments (8) avant serrage des vis de pression (9), tandis que la figure 4 montre les éléments (8) après serrage desdites vis de pression (9). On voit qu'après l'action de serrage, la face inclinée (8a3) est en appui sur le bord périphérique de la cible (2).

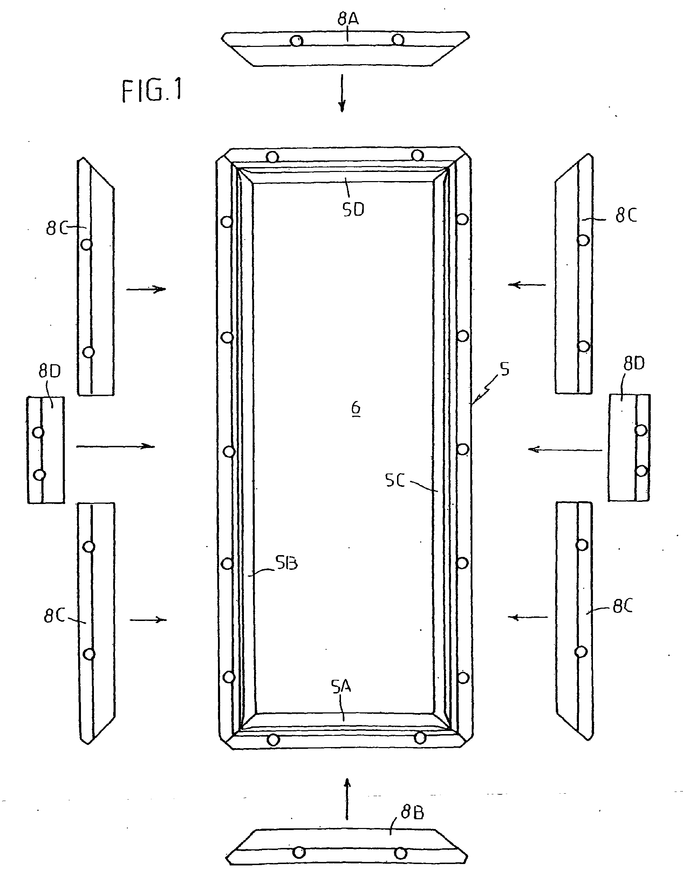

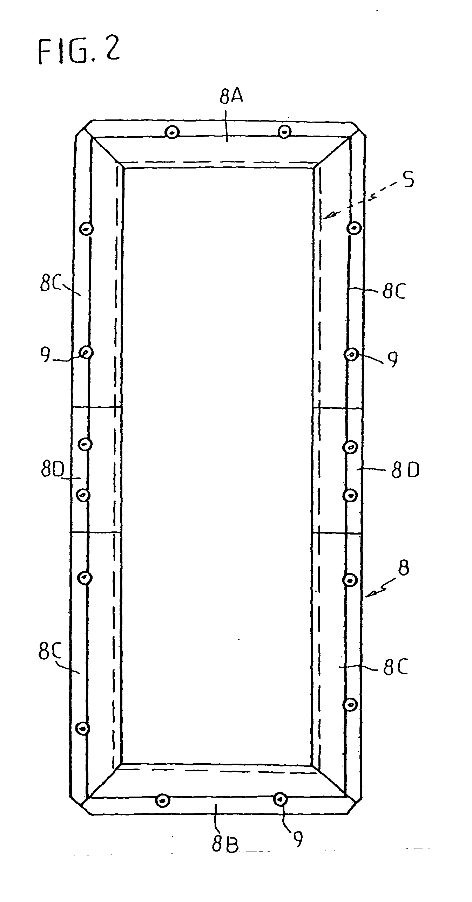

Comme le montrent les figures 1 et 2, les éléments de pincement (8) sont convenablement découpés pour constituer, après assemblage en juxtaposition, un cadre périphérique fermé entourant et enfermant totalement les 4 côtés de la cible (2) en délimitant une zone centrale libre pour la pulvérisation. Autrement dit, après assemblage, les éléments (8) reproduisent la même forme géométrique que celle du cadre (5).

Compte tenu de l'imbrication des formes des profils d'accrochage des éléments (8) et du cadre (5), les différents éléments (8) sont indépendants les uns des autres. Certains présentent au moins un bord biseauté pour former les angles, tandis que d'autres sont droits pour être insérés par glissement entre deux éléments notamment, préalablement positionnés par rapport au cadre (5).

Si l'on considère l'exemple illustré figures 1 et 2, les éléments de pincement (8) sont constitués de deux éléments (8A) et (8B) correspondant aux deux petits côtés du cadre, ces deux éléments (8A) (8B) étant biseautés à chacune de leurs extrémités, de quatre éléments (8C) biseautés à l'une de leur extrémité pour être positionnés en relation avec les éléments (8A) et (8B) et enfin de deux éléments (8D) destinés à être insérés, après montage de deux éléments (8C) considérés du même côté du cadre.

Compte tenu de ces dispositions, il apparaît que le montage et démontage de la cible (2) est particulièrement simple et rapide. En effet, il suffit de démonter les éléments de pincement (8) en desserrant les vis de pression (9).

De la même façon la mise en place d'une nouvelle cible (2) s'effectue très rapidement. Après l'avoir positionnée à l'intérieur du cadre (7), il suffit de remettre en place, comme indiqué, les éléments de pincement (8) et de serrer les vis de pression (9) de manière à provoquer le basculement desdits éléments (8) (figure 4). Il apparaît donc que ce sont les profils conjugués des éléments de pincement (8) et du cadre (5), qui assurent la fixation de la cible et non pas des vis de serrage.

Selon une caractéristique importante de l'invention, l'ensemble de la cathode telle que définie selon les caractéristiques de l'invention, est montée au niveau de la culasse (1), sur une partie de la machine agencée pour être facilement extractable. Cette partie de la machine peut avantageusement être constituée par une porte (10).

A noter que les éléments de pincement (8) sont, ou non, dans le même matériau que celui de la cible de pulvérisation.

Les avantages ressortent bien de la description.

## Revendications

1. Cathode pour machine de traitement par pulvérisation sous vide comprenant une plaque cible (2), un support (3), et un cadre (5), la plaque cible (2) étant montée sur le support (3) agencé pour faire office de refroidisseur, le support (3) étant rendu solidaire du cadre (5) délimitant un espace fermé (6) pour le positionnement et le centrage de la cible (2), **caractérisé en ce que** ledit cadre (5) présente périphériquement un rebord d'accrochage profilé (5d) coopérant avec un ensemble d'éléments indépendants de pincement (8) faisant partie de la cathode et présentant des formes d'accrochage complémentaires (8a) aptes à autoriser un effet de basculement desdits éléments (8) résultant d'une action de serrage exercée sur des organes (9), engagés dans l'épaisseur des éléments, et en appui sur une partie du rebord d'accrochage du cadre (5), de sorte que sous ledit effet de basculement une partie des formes d'accrochage de l'ensemble d'éléments de pincement (8), prend appui facialement sur le bord périphérique de la cible (2) en vue de sa fixation.

2. Cathode selon la revendication 1, **caractérisée en ce que** l'ensemble des éléments de pincement (8) sont convenablement découpés pour constituer, après assemblage en juxtaposition, un cadre périphérique fermé entourant et enfermant totalement les quatre côtés de la cible (2) en délimitant une zone de centrage libre pour la pulvérisation.

3. Cathode selon la revendication 2, **caractérisée en ce que** certains des éléments (8) présentent au moins un bord biseauté pour former les angles tandis que d'autres sont droits pour être insérés par glissement, entre deux éléments d'angle notamment, préalablement positionnés par rapport au cadre.

4. Cathode selon la revendication 1, **caractérisée en ce que** les organes (9) sont des vis de pression.

5. Cathode selon la revendication 1, **caractérisée en ce que** les rebords d'accrochage et d'emboîtement du cadre (5) sont constitués par un profil rectiligne déporté délimitant une rainure rectiligne (5d2).

6. Cathode selon l'une quelconque des revendications 1 et 5, **caractérisée en ce que** les formes complémentaires d'accrochage des éléments de pincement (8), sont constituées par une gorge rectiligne (8a1) coopérant avec le profil rectiligne déporté du cadre (5) et délimitant un bec coopérant avec la rainure (5d2) pour provoquer l'effet de basculement sous l'action de serrage.

7. Cathode selon la revendication 1, **caractérisée en ce que** le support est à membrane (4).

8. Cathode selon la revendication 1, **caractérisée en ce que** les éléments de pincement (8) sont, ou non, dans le même matériau que celui de la cible de pulvérisation (2).

9. Méthode d'utilisation de cacathode selon la revendication 1, **caractérisée en ce que** le support (3) est monté sur une partie de la machine agencée pour être facilement extractable.

10. Méthode selon la revendication 9, **caractérisée en ce que** la partie de la machine constitue une porte.

## Claims

1. A cathode for a vacuum spraying machine comprising a target plate (2), a holder (3) and a frame (5), the target plate (2) being mounted on holder (3) designed to act as a cooler, holder (3) being attached to frame (5) delimiting a confined space (6) for positioning and centring the target (2), **characterised in that** said frame (5) has a peripheral shaped locking flange (5d) that cooperates with a set of independent grippers (8) that are part of the cathode and have matching locking shapes (8a) capable of allowing swivelling of said grippers (8) resulting from a clamping action exerted on components (9) engaged in the thickness of the grippers and pushed against part of the locking flange of frame (5) so that due to said swivelling, some of the locking shapes of the set of grippers (8) frontally press against the peripheral edge of target (2) in order to fix it.

2. A cathode as claimed in claim 1, **characterised in that** the set of grippers (8) are conveniently cut out to constitute, after juxtaposed assembly, a closed peripheral frame completely surrounding and enclosing the four sides of the target (2) and delimiting a free centring area for spraying.

3. A cathode as claimed in claim 2, **characterised in that** certain grippers (8) have at least one bevelled edge to form angles whereas the other grippers are straight so that they can be inserted by sliding them between two corner elements in particular that were previously positioned relative to the frame.

4. A cathode as claimed in claim 1, **characterised in that** components (9) are set screws.

5. A cathode as claimed in claim 1, **characterised in that** the jointing and locking flanges of frame (5) consist of an offset straight section delimiting a straight groove (5d2).

6. A cathode as claimed in either claim 1 or 5, **characterised in that** the matching locking shapes of grippers (8) consist of a straight channel (8a1) that cooperates with the offset straight section of frame (5) and delimits a tongue that cooperates with groove (5d2) in order to cause swivelling due to the action of clamping.

7. A cathode as claimed in claim 1, **characterised in that** the holder has a membrane (4).

8. A cathode as claimed in claim 1, **characterised in that** the grippers (8) are or are not made of the same material as that of the spray target (2).

9. A method of using the cathode as claimed in claim 1, **characterised in that** the holder (3) is mounted on a part of the machine designed to be easily extractable.

10. A method as claimed in claim 9, **characterised in that** the part of the machine constitutes a door.

## Patentansprüche

1. Kathode für eine Vakuumzerstäubungsbehandlungsvorrichtung mit einer Zielplatte (2), einer Auflage (3) und einem Rahmen (5), wobei die Zielplatte (2) an der Auflage (3) montiert ist, welche als Kühler dient, und mit dem Rahmen (5) verbunden ist, der einen geschlossenen Raum (6) für die Positionierung und Zentrierung der Zielplatte (2) begrenzt, **dadurch gekennzeichnet, dass** der Rahmen (5) am Umfang eine profilierte Randleiste zum Einhängen (5d) aufweist, die mit einem System unabhängiger Klemmelemente (8) zusammenwirkt, die Teil der Kathode sind und zusätzliche Einhängeabschnitte (8a) bilden, die eine Kipp- bzw. Neigewirkung der Elemente (8) ermöglichen, welche sich aus einer Einspannung ergeben, die auf Bauteile (9) ausgeübt wird, die in die Elemente eingreifen und sich auf einem Teil der Randleiste zum Einhängen des Rahmens (5) abstützen, so dass sich unter der Kippwirkung ein Teil der Einhängeabschnitte des Systems der Klemmelemente (8) frontal an dem Umfangsrand der Zielplatte (2) im Hinblick auf seine Befestigung abstützt.

2. Kathode nach Anspruch 1, **dadurch gekennzeichnet, dass** das System der Klemmelemente (8) zweckentsprechend zugeschnitten ist, so dass es nach der Montage nebeneinander einen geschlossenen Umfangsrahmen bildet, der die vier Seiten der Zielplatte (2) völlig umgibt und umschließt, indem er eine freie Zentrierzone für die Zerstäubung begrenzt.

3. Kathode nach Anspruch 2, **dadurch gekennzeichnet, dass** einige der Elemente (8) mindestens eine abgeschrägte Kante besitzen, um die Winkel zu bilden, während andere gerade sind, um durch Gleiten insbesondere zwischen zwei Winkelelementen eingeschoben zu werden, die zuvor gegenüber dem Rahmen positioniert worden sind.

4. Kathode nach Anspruch 1, **dadurch gekennzeichnet, dass** es sich bei den Bauteilen (9) um Druckschrauben handelt.

5. Kathode nach Anspruch 1, **dadurch gekennzeichnet, dass** die Randleisten zum Einhängen und zum Einstecken des Rahmens (5) aus einem geraden, versetzten Profil bestehen, das eine gerade Einkerbung begrenzt.

6. Kathode nach einem der vorhergehenden Ansprüche 1 bis 5, **dadurch gekennzeichnet, dass** die zusätzlichen Einhängeabschnitte der Klemmelemente (8) aus einer geraden Rille (8a1) bestehen, die mit dem geraden, versetzten Profil des Rahmens (5) zusammenwirkt und eine Nase begrenzt, die mit der Einkerbung (5d2) zusammenwirkt, um die Kipp- bzw. Neigwirkung unter der Einspannung hervorzurufen.

7. Kathode nach Anspruch 1, **dadurch gekennzeichnet, dass** es sich bei der Auflage um eine Membranauflage (4) handelt.

8. Kathode nach Anspruch 1, **dadurch gekennzeichnet, dass** die Klemmelemente (8) aus demselben Material bestehen können wie die Platte (2) für die Zerstäubung oder auch nicht.

9. Verwendungsverfahren für die Kathode nach Anspruch 1, **dadurch gekennzeichnet, dass** die Auflage (3) an einem Teil der Vorrichtung montiert ist, der derart angeordnet ist, dass er leicht herausziehbar ist.

10. Verfahren nach Anspruch 9, **dadurch gekennzeichnet, dass** der Teil der Vorrichtung eine Tür aufweist.
